# FASCICULE DE BREVET EUROPEEN

(11) **EP 0 734 461 B1**
(45) Date de publication et mention de la délivrance du brevet: **21.04.1999**
(21) Numéro de dépôt: 95902837.4
(22) Date de dépôt: 07.12.1994
(51) Int. Cl.: C23C 16/44, C23C 16/50

(54) **PROCEDE ET APPAREIL DE FORMATION DE GAZ EXCITE**
VERFHAREN UND VORRICHTUNG ZUR HERSTELLUNG ANGEREGTER GASE
PROCESS AND APPARATUS FOR FORMING AN EXCITED GAS

(30) Priorité: 15.12.1993 FR 9315111
(43) Date de publication de la demande: 02.10.1996
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: SINDZINGRE, Thierry, F-94230 Cachan (FR); RABIA, Stéphane, 14, résidence du Parc du Château, F-91100 Gif-sur-Yvette (FR); COEURET, François, F-78280 Guyancourt (FR)
(74) Mandataire: Vesin, Jacques
(86) Numéro de dépôt international: FR9401422
(87) Numéro de publication internationale: WO9516801

(56) Documents cités:
- EP-A- 0 513 634
- US-A- 4 774 062
- US-A- 4 951 602

## Description

L'invention concerne le domaine des traitements de surface de substrats non métalliques, en particulier les substrats polymères, textiles (fibres ou pièces de laine de coton etc..) papier, verre, ou encore, bois, platre, ou tuile, que ces substrats soient plats ou qu'ils se présentent sous la forme d'un volume. Ces traitements de surface sont le plus souvent pratiqués dans le but d'améliorer l'aptitude de ces substrats à l'adhésion et à la mouillabilité. Ils ont fait l'objet d'un grand nombre de travaux, permettant notamment de dégager les catégories suivantes de méthodes :
- Les traitements en phase liquide,
- Les traitements plasma (à basse pression),
- Les traitements par décharges couronnes,
- Le flammage,
- Les dépôts de silice en phase gazeuse sous plasma ou par pulvérisation cathodique.

Ces méthodes ne sont toutefois pas pleinement satisfaisantes et comportent un certain nombre d'inconvénients non négligeables.

Ainsi, pour ce qui est du flammage, la méthode s'avère difficile à contrôler, en particulier difficile à appliquer à des surfaces non planes.

Les inconvénients des méthodes en phase liquide sont liés à des problèmes d'environnement, notamment du fait du retraitement des bains avant rejet, mais sont aussi liés à des problèmes de séchage après traitement.

Pour ce qui est des traitements plasma, que ces traitements soient utilisés pour réaliser l'activation de la surface du substrat ou pour effectuer un dépôt de silice sur cette surface, ils sont le plus souvent pratiqués sous vide ou sous basse pression, ce qui représente une complexité et un surcoût non négligeable, relativement incompatible avec la faible valeur ajoutée de ces produits, notamment des polymères.

Dans ce contexte, la demanderesse a récemment proposé dans le document FR-A-2,670, 506, un procédé pour le dépôt d'une couche mince d'oxyde de silicium sur un substrat en polyoléfine. Ce procédé permettait d'effectuer successivement ou de façon concomitante la préactivation de la surface polymère par décharge couronne, puis le dépôt d'une couche d'oxyde de silicium par exposition de la surface ainsi préactivée à une atmosphère contenant un silane, ceci s'effectuant à la pression atmosphérique.

Si ce procédé constitue indiscutablement une avancée par rapport aux techniques existantes, la Demanderesse a mis en évidence le fait qu'il peut être amélioré, notamment en ce que :
- La distance entre l'échantillon à traiter et l'électrode est critique pour l'obtention d'un traitement parfaitement homogène, ce qui constitue une contrainte lorsqu'il est nécessaire de traiter des substrats d'épaisseur variable ou variable d'un substrat à l'autre.
- D'autre part, la mise en oeuvre du procédé nécessite que les substrats passent au sein de la décharge, d'où une source de pollution pour les électrodes du fait de la présence de poussières ou de particules grasses à la surface de ces substrats.
- Lorsque le procédé réalise de façon concomitante la préactivation et le dépôt, le précurseur gazeux du silicium (silane) est introduit directement dans la décharge, d'où le risque de déposer des oxydes de silicium sur les électrodes.
- Enfin, la configuration géométrique permettant la mise en oeuvre de ce procédé limitait la densité de puissance que l'on pouvait mettre en oeuvre, une augmentation de la densité de puissance au delà de cette limite risquant d'entraîner une délocalisation du nuage ionisé.
- Par ailleurs, dans une telle configuration de décharge couronne, le substrat est exposé à un plasma, qui comme son nom l'indique comporte des espèces électriquement chargées, ce qui n'est pas sans poser des problèmes dans le cas de matériaux isolants comme le sont les polymères pour lesquels on assiste à une accumulation de charges.

Dans un contexte plus général, la demanderesse a dans le document FR-A-2,692,730, dont le contenu est supposé intégré ici pour référence, récemment proposé un dispositif de formation de molécules excitées ou instables fonctionnant sensiblement à la pression atmosphérique, et permettant d'atteindre des densités énergétiques améliorées.

Dans ce contexte, la présente invention a pour objet de proposer un procédé amélioré pour former un dépôt d'un film contenant du silicium sur un substrat non métallique, permettant :
- d'opérer à pression atmosphérique,
- de pouvoir travailler à basse température, selon le substrat considéré,
- une grande flexibilité de distance entre l'objet à traiter et le dispositif utilisé pour effectuer ce traitement,
- d'offrir une densité énergétique améliorée, permettant d'atteindre une vitesse de traitement accrue,
- d'éviter la mise en contact du substrat avec des espèces électriquement chargées,
- d'éviter que le précurseur gazeux du silicium utilisé ne soit mis en situation de donner lieu à des réactions à l'intérieur du dispositif en question (dépot de poudre),
- d'éviter que le substrat sur lequel doit être effectué le dépôt n'ait à passer au sein de ce dispositif.

Pour ce faire, selon le procédé de l'invention, on forme un dépôt d'un film contenant du silicium sur un substrat non métallique avec un appareil aval de formation d'espèces gazeuses excitées ou instables, dans lequel un mélange gazeux initial de traitement est transformé en un mélange gazeux primaire de traitement, l'appareil aval étant le siège d'une décharge électrique créée entre une première électrode et une seconde électrode, qui s'étendent selon une direction principale allongée, le mélange gazeux initial de traitement traversant la décharge transversalement aux électrodes et à cette direction principale, le mélange gazeux primaire de traitement obtenu à la sortie de gaz de l'appareil, qui comprend des espèces gazeuses excitées ou instables et qui est substantiellement dépourvu d'espèces électriquement chargées, formant avec un mélange gazeux adjacent de traitement qui comprend au moins un précurseur gazeux du silicium et qui n'a pas transité par l' appareil, l'atmosphère gazeuse de traitement qui est mise en contact avec le substrat pour réaliser le dépôt.

Une couche d'un matériau diélectrique est avantageusement disposée sur la surface d'au moins une des électrodes, en regard de l'autre électrode.

L'énergie mise en oeuvre dans l'appareil aval, ramenée à l'unité de surface de diélectrique sera alors avantageusement supérieure à 1W/cm², préférentiellement supérieure à 10 W/cm².

La mise en contact de l'atmosphère gazeuse de traitement avec le substrat, pour réaliser le dépôt, est avantageusement effectuée à une pression voisine de la pression atmosphérique.

On entend par pression voisine de la pression atmosphérique selon l'invention, une pression se situant dans l'intervalle [0,1 x 10⁵ Pa, 3 x 10⁵ Pa].

On entend par substrat non métallique, selon l'invention, un substrat dans un matériau organique ou encore céramique, par exemple polymère, textile (fibres ou pièces de laine de coton etc..) papier, verre, ou encore bois, platre ou tuile, que ces substrats soient plats ou qu'ils se présentent sous la forme d'un volume.

On entend par l'expression "précurseur gazeux du silicium" selon l'invention, un gaz tel que par exemple le silane, le disilane ou tout autre précurseur gazeux classiquement utilisé pour de telles applications de dépot à base de silicium.

Selon un des aspects de l'invention, au préalable, le substrat aura subit une préparation de surface par mise en contact avec une atmosphère gazeuse de préparation de surface, l'atmosphère gazeuse de préparation comprenant un mélange gazeux primaire de préparation, et le cas échéant, un mélange gazeux adjacent de préparation, le mélange gazeux primaire de préparation étant obtenu à la sortie de gaz d'au moins un appareil amont de formation d'espèces gazeuses excitées ou instables dans lequel a été transformé un mélange gazeux initial de préparation comprenant un gaz réducteur ou un gaz oxydant et le cas échéant au moins un gaz inerte, le mélange gazeux primaire de préparation étant substantiellement dépourvu d'espèces électriquement chargées, et le mélange gazeux adjacent de préparation n'ayant pas transité par l'appareil amont et ne contenant aucun précurseur gazeux du silicium.

Ici encore, la mise en contact avec l'atmosphère gazeuse de préparation de surface sera avantageusement effectuée à une pression voisine de la atmosphérique.

L' appareil amont selon l'invention est constitué par tout dispositif permettant "d'exciter" le mélange gazeux initial de préparation, pour obtenir, en sortie de gaz de l'appareil, un autre mélange gazeux comportant des espèces gazeuses instables ou excitées, ce dernier mélange gazeux (primaire de préparation) étant substantiellement dépourvu d'espèces électriquement chargées, donc d'ions ou d'électrons.

Un tel appareil amont, dans lequel est transformé le mélange gazeux initial de préparation, est avantageusement le siège d'une décharge électrique créée entre une première électrode et une seconde électrode, toutes deux s'étendant selon une direction principale allongée, le mélange gazeux initial de préparation traversant la décharge transversalement aux électrodes et à cette direction principale.

Une couche d'un matériau diélectrique est avantageusement disposée sur la surface d'au moins une des électrodes, en regard de l'autre électrode.

L'énergie mise en oeuvre dans l'appareil amont, ramenée à l'unité de surface de diélectrique sera alors avantageusement supérieure à 1W/cm², préférentiellement supérieure à 10 W/cm².

Comme il apparaîtra clairement à l'homme du métier, l'atmosphère de traitement selon l'invention est obtenue par la combinaison du mélange gazeux primaire de traitement obtenu en sortie d'un tel appareil (dit aval) de formation d'espèces gazeuses excitées ou instables, mélange gazeux primaire de traitement qui comprend donc de telles espèces gazeuses excitées ou instables, et du mélange gazeux adjacent de traitement, le mélange gazeux primaire de traitement transférant tout ou partie de son énergie au précurseur gazeux du silicium compris dans le mélange gazeux adjacent de traitement et à la surface du substrat à traiter, permettant ainsi le dépôt.

De même, l'atmosphère de préparation, selon l'invention, est obtenue par la combinaison du mélange gazeux primaire de préparation, obtenu en sortie d'un tel appareil (dit amont) de formation d'espèces gazeuses excitées ou instables, mélange gazeux primaire de préparation qui comprend donc de telles espèces gazeuses excitées ou instables, et le cas échéant, du mélange gazeux adjacent de préparation.

Le précurseur gazeux du silicium n'ayant pas transité par l'appareil aval, le risque de dépôt de poudre de silice (ou plus généralement de composé de silicium) à l'intérieur de la décharge est de ce fait éliminé. Le substrat n'est par ailleurs en contact qu'avec la sortie de gaz de l'appareil considéré, il n'a pas "séjourné" dans l'appareil.

On peut qualifier cette configuration de "post-décharge" puisque la composante primaire de l'atmosphère de traitement, qui comprend des espèces gazeuses excitées ou instables, est obtenue en sortie d' appareil, ce qui assure l'absence substancielle de toute espèce électriquement chargée dans cette composante primaire. La composante adjacente de l'atmosphère de traitement, qui n'a pas transité par l'appareil, en est à fortiori dépourvue.

Par ailleurs, cette configuration permet de nettement séparer le lieu de la génération de la composante primaire de l'atmosphère du lieu de son utilisation, ce qui présente un avantage non négligeable en terme de pollution de l'appareil (éviter que les dégagements divers résultant de l'opération de dépot n'aillent polluer l'intérieur de l'appareil, par exemple ses électrodes). Enfin, la pièce, qui n'est pas traitée au sein de l'appareil (par exemple au sein de la décharge entre les électrodes), bénéficie d'une bien meilleure fléxibilité sur l'aspect "distance" évoqué plus haut.

La nature et la structure du composé du silicium déposé (SiO_{X}N_{Y}, SiO_{X}, voire SiO_{X}N_{Y}H_{Z}) sera étroitement liée aux conditions expérimentales utilisées, notamment aux pressions partielles d'oxygène et d'azote dans l'atmosphère de traitement. Il sera par exemple possible de contrôler la nature du film déposé en jouant notamment sur la nature du gaz inerte utilisé tant dans le mélange initial de traitement que dans le mélange adjacent de traitement, mais aussi sur le niveau de la pression partielle d'oxygène maintenue au sein de l'atmosphère de traitement.

Comme il apparaîtra clairement à l'homme du métier, le substrat à traiter, tant pour l'opération de traitement proprement dite que pour l'opération préliminaire de préparation de surface, pourra être mis en contact avec la sortie de gaz d'un seul appareil ou avec les sorties de gaz de plusieurs appareils de formation d'espèces gazeuses excitées ou instables placées en parallèle sur la largeur du substrat ou successivement avec les sorties de gaz de plusieurs appareils de formation d'espèces gazeuses excitées ou instables placées en série.

De même, l'opération de traitement proprement dite comme l'opération préliminaire de préparation de surface pourront intervenir sur une seule des faces du substrat comme sur ses deux faces. Dans ce dernier cas, il conviendra de disposer les appareils requis en regard de chaque face de la pièce.

Comme il apparaîtra aussi clairement à l'homme du métier, le ou les appareils de formation d'espèces gazeuses excitées ou instables utilisés durant l'opération de préparation de surface (du genre amont) pourront être identiques ou de structure différente du ou des appareils utilisés pour l'opération de traitement proprement dite (du genre aval).

Le cas échéant, le substrat à traiter aura au préalable subit une autre étape de préparation de surface selon l'une quelconque des multiples méthodes disponibles, que ce soit en phase liquide ou en phase gazeuse.

Selon une des mises en oeuvre de l'invention, le mélange gazeux initial de traitement comprend un gaz inerte et/ou un gaz réducteur et/ou un gaz oxydant. Le gaz inerte peut par exemple consister en de l'azote, de l'argon, de l'hélium ou un mélange de tels gaz inertes. Le gaz réducteur peut par exemple consister en de l'hydrogène, du CH₄ ou encore de l'amoniac ou un mélange de tels gaz réducteurs. Le gaz oxydant peut quant à lui par exemple consister en de l'oxygène, ou du CO₂, ou encore du N₂O, H₂O, ou un mélange de tels gaz oxydants. La liste de gaz donnés dans chaque catégorie n'étant qu'indicative, nullement limitative.

Le mélange gazeux adjacent de traitement comprendra avantageusement, en dehors du ou des précurseurs gazeux du silicium, un gaz inerte et/ou un gaz réducteur, et comprendra le cas échéant un gaz oxydant. Selon une des mises en oeuvre de l'invention, le précurseur gazeux du silicium du mélange gazeux adjacent de traitement est du monosilane SiH₄.

En revanche, dans le cas du mélange gazeux adjacent de préparation, qui selon l'invention est dépourvu de précurseurs gazeux du silicium, il comprendra avantageusement, un gaz inerte et/ou un gaz réducteur et/ou un gaz oxydant.

Selon un des aspects de l'invention, le substrat à traiter est porté à une température comprise entre la température ambiante et 200°C. Comme il apparaîtra clairement à l'homme du métier, la température mise en oeuvre dépendra très largement du substrat traité, elle pourra par exemple être réduite (voire maintenue à la température ambiante) dans le cas de polymères ne pouvant supporter des températures élevées.

Selon une des mises en oeuvre de l'invention, le substrat à traiter est amené en regard de la sortie de gaz de l'appareil aval de formation d'espèces gazeuses excitées ou instables, le cas échéant, en regard des sorties de gaz de plusieurs appareils aval placés en parallèle sur la largeur du substrat et/ou successivement en regard des sorties de gaz de plusieurs appareils aval placés en série par un système de convoyage traversant un espace intérieur délimité par un ensemble de capotage aval (par exemple un tunnel ou un ensemble de capotages élémentaires), isolé de l'atmosphère environnante, ledit ensemble aval étant raccordé de façon étanche audit appareil aval ou incluant ledit appareil aval.

Selon une autre mise en oeuvre de l'invention, le substrat dont la surface est à préparer est amené en regard de la sortie de gaz de l'appareil amont de formation d'espèces gazeuses excitées ou instables, le cas échéant, en regard des sorties de gaz de plusieurs appareils amont placés en parallèle sur la largeur du substrat et/ou successivement en regard des sorties de gaz de plusieurs appareils amont placés en série par un système de convoyage traversant un espace intérieur délimité par un ensemble de capotage amont, isolé de l'atmosphère environnante, ledit ensemble amont étant raccordé de façon étanche audit appareil amont ou incluant ledit appareil amont.

On pourra alors avantageusement passer continûment du tunnel ou ensemble amont au tunnel ou ensemble aval.

Selon une des mises en oeuvre de l'invention, on réalise un zonage de l'atmosphère de traitement rencontrée successivement par la pièce à traiter le long du convoyeur, de la façon suivante :
a) au moins un des appareils aval de formation d'espèces gazeuses excitées ou instables, transforme un mélange gazeux initial de traitement différent de celui transformé par l'appareil aval le précédant dans le dit ensemble, et/ou
b) le mélange gazeux adjacent de traitement mis en oeuvre au niveau d'au moins un des appareils aval de formation d'espèces gazeuses excitées ou instables est différent de celui mis en oeuvre au niveau de l'appareil aval le précédant dans le dit ensemble.

Selon une des mises en oeuvre de l'invention, les étapes a) et b) ci-dessus pourront concerner un même appareil aval.

On pourra ainsi par exemple utiliser des mélanges de pouvoir réducteur croissant, d'un appareil à l'autre ou encore jouer sur ce paramètre "composition successive de l'atmosphère de traitement" pour réaliser des dépôts multicouches, chaque couche étant d'épaisseurs et de structures différentes et contrôlées.

Selon une autre mise en oeuvre de l'invention, on réalise un zonage de l'atmosphère de préparation rencontrée successivement par la pièce, dont la surface doit être préparée, le long du convoyeur, de la façon suivante :
a) au moins un des appareils amont de formation d'espèces gazeuses excitées ou instables, transforme un mélange gazeux initial de préparationt différent de celui transformé par l'appareil amont le précédant dans le dit ensemble, et/ou
b) le mélange gazeux adjacent de préparation mis en oeuvre au niveau d'au moins un des appareils amont de formation d'espèces gazeuses excitées ou instables est différent de celui mis en oeuvre au niveau de l'appareil amont le précédant dans le dit ensemble.

Selon une des mises en oeuvre de l'invention, les étapes a) et b) ci-dessus pourront concerner un même appareil amont.

L'invention concerne aussi un dispositif, convenant notamment pour la mise en oeuvre de l'invention, comprenant un ensemble de capotage définissant un espace intérieur traversé par des moyens de convoyage des substrats non métalliques à traiter, isolé de l'atmosphère environnante, se raccordant de façon étanche à ou incluant un ou plusieurs appareils de formation d'espèces gazeuses excitées ou instables montés en série et/ou parallèle, comprenant au moins un passage de gaz tubulaire ayant un axe, formé entre une électrode extérieure et une électrode intérieure, l'une au moins des électrodes comportant, en regard de l'autre, un revêtement diélectrique, les électrodes étant reliées à une source haute tension et haute fréquence, l'électrode extérieure entourant le diélectrique et comportant une entrée de gaz initial et une sortie de gaz primaire allongées, parallèles à l'axe et sensiblement diamétralement opposées, ladite sortie de gaz débouchant à l'intérieur dudit ensemble, qui est muni d'au moins un moyen d'injection d'un gaz adjacent n'ayant pas transité par le ou lesdits appareils.

D'autres caractéristiques et avantages de la présente invention ressortiront de la description suivante de mode de réalisation donnée à titre illustratif mais nullement limitatif, fait en relation avec les dessins annexés sur lesquels :
- La figure 1 est une représention schématique d'un dispositif simplifié convenant pour la mise en oeuvre de l'invention.
- La figure 2 est une représentation schématique d'un mode de réalisation de l'invention comprenant un tunnel.
- La figure 3 est une représentation schématique en section d'un appareil de formation d'espèces gazeuses excitées ou instables convenant pour la mise en oeuvre de l'invention.

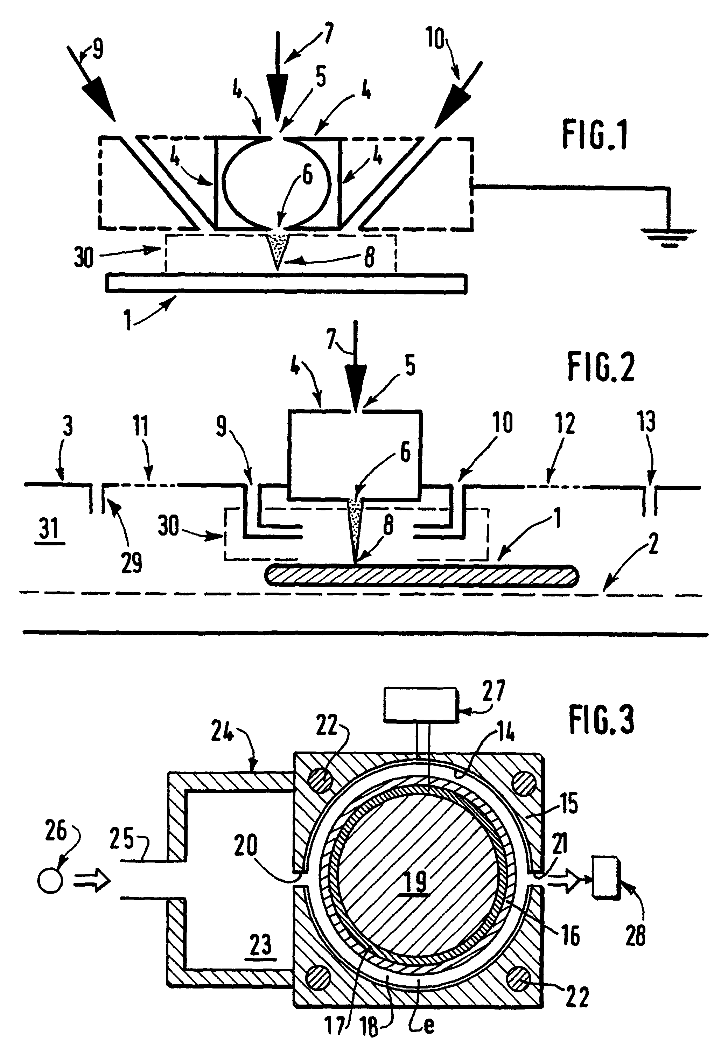

Est schématisé, sur la figure 1 en 4, un appareil de formation d'espèces gazeuses instables ou excitées (appareil dit "aval" compte tenu qu'il est utilisé pour effectuer le dépôt), alimenté en son entrée de gaz 5 par un mélange gazeux initial de traitement 7. Est obtenu en sortie de gaz 6, un mélange gazeux primaire de traitement 8. Un substrat 1 placé en regard de cette sortie de gaz 6 voit par ailleurs un mélange adjacent de traitement qui arrive, sur le mode de réalisation représenté, par deux entrées de gaz 9, 10, ce mélange adjacent de traitement ne transitant pas par l'appareil de formation d'espèces gazeuses excitées ou instables 4.

On a symbolisé sur cette figure 1, par le rectangle en tirets 30, la zone où interagissent les mélanges de gaz primaire et adjacent de traitement de façon à réaliser le dépôt contenant du silicium sur le substrat 1.

On reconnaît sur la figure 2 qui est un mode de réalisation particulier de l'invention, un tunnel 3 délimitant un espace intérieur 31, dans lequel est convoyé le substrat 1, grâce à un moyen de convoyage 2.

Le substrat 1 est amené en regard de la sortie de gaz 6 d'un appareil (aval) de formation d'espèces gazeuses excitées ou instables 4 où il entre en contact avec le mélange gazeux primaire de traitement 8 obtenu à partir du mélange initial de traitement 7 et avec le mélange adjacent de traitement qui entre par des entrées de gaz 9 et 10, ce mélange adjacent de traitement n'ayant lui pas transité par l'appareil 4.

Ici encore, on a schématisé par le rectangle en tirets 30, la zone d'interaction entre le mélange gazeux primaire de traitement 8 et le mélange adjacent de traitement arrivant par les entrées de gaz 9 et 10.

Le mode de réalisation représenté sur la figure 2 permet de traiter le substrat 1 par plusieurs appareils aval de formation d'espèces gazeuses instables ou excitées placés en série, les appareils placés en 11 et 12 n'ayant pas été représentés, les symboles 13 et 29 illustrent des exemples supplémentaires d'entrées de mélange adjacent de traitement.

Il est à noter, que l'appareil de formation d'espèces gazeuses excitées ou instables en localisation 11 pourrait aussi être du genre "amont", et donc être utilisé pour effectuer l'étape préliminaire de préparation de surface selon l'invention, le mélange gazeux adjacent de préparation (29) lui correspondant ne contenant alors aucun précurseur gazeux du silicium.

On reconnaît sur la figure 3, qui représente schématiquement une section d'un appareil de formation d'espèces gazeuses excitées ou instables convenant pour la mise en oeuvre de l'invention, que ce soit pour un appareil du genre amont ou aval (appareil qui est pour ce mode de réalisation de géométrie cylindrique), une première électrode tubulaire 14 formée par exemple par une face interne d'un bloc métallique 15, et dans laquelle est disposé, concentriquement, un ensemble d'un tube en matériau diélectrique 16, par exemple en céramique, sur la face interne duquel est déposée, par métallisation, une deuxième électrode 17 (exagérément épaissie sur la figure 3 pour une meilleure compréhension).

L'ensemble du diélectrique 16 et de la deuxième électrode 17 définis ainsi avec la première électrode 14, un passage tubulaire de gaz 18, et intérieurement, un volume interne 19 dans lequel on fait circuler un réfrigérant, avantageusement un Fréon pour son caractère électronégatif, ou encore de l'eau permutée.

Le passage de gaz interne 18 a une extension axiale inférieure à 1 m, typiquement inférieure à 50 cm, et son épaisseur radiale e n'excède pas 3 mm et est typiquement inférieure à 2,5 mm. Le bloc 15 comporte diamétralement opposées, deux fentes longitudinales 20 et 21, formant respectivement l'entrée du gaz initial à exciter dans le passage 18 et la sortie du flux de gaz primaire comportant des espèces excitées ou instables.

Les fentes 20 et 21 s'étendent sur toute la longueur axiale de la cavité 18 et ont une hauteur qui, pour le mode de réalisation représenté, n'excède pas l'épaisseur e et est typiquement sensiblement identique à cette dernière.

Le corps 15 est formé avantageusement, à la périphérie de la première électrode 14, avec une pluralité de conduits 22 pour le passage d'un réfrigérant, par exemple de l'eau.

L'entrée de gaz 20 communique avec une chambre ou plénum d'homogénéisation 23 formée dans un boîtier 24 accolé au bloc 15 et comportant une tubulure 25 d'amenée de mélange gazeux initial, à une pression comprise dans l'intervalle [0,1 x 10⁵ Pa, 3 x 10⁵ Pa] en provenance d'une source de mélange gazeux initial 26.

Les électrodes sont reliées à un générateur électrique haute tension et haute fréquence 27 fonctionnant à une fréquence supérieure à 15 kHz et délivrant une puissance par exemple de l'ordre de 10 kW. On pourra d'ailleurs avantageusement exprimer cette puissance délivrée par le générateur en la ramenant à la surface de diélectrique.

Le flux gazeux contenant les espèces excitées disponible à la sortie 21 est adressé à un poste utilisateur 28, par exemple pour le dépôt d'une couche contenant du silicium sur un substrat, ou encore pour effectuer une étape de préparation de surface d'un substrat.

Une installation telle que celle décrite en relation avec la figure 2 comprenant un unique appareil 4 de formation d'espèces gazeuses excitées ou instables (donc du genre aval) tel que celui décrit en relation avec la figure 3 a été utilisé pour réaliser un exemple de mise en oeuvre de l'invention. Pour ce faire, des échantillons de films plastiques d'emballage en polypropylène de dimensions 10 cm x 10 cm, ont été traités dans les conditions suivantes :
- l'échantillon n'était pas chauffé,
- la densité d'énergie mise en oeuvre sur le diélectrique était de l'ordre de 15 W/cm²,
- le mélange gazeux initial de traitement était de l'azote, à un débit de 10 m³/h,
- le mélange gazeux adjacent de traitement, ne transitant pas l'appareil de formation d'espèces gazeuses excitées ou instables, était constitué par un débit de 5 litres/minute d'une source initiale à 2% de silane dans l'argon,
- la pression partielle d'oxygène résiduelle au dessus des films était de l'ordre de 10 ppm,
- la distance film/sortie de gaz était de 5 mm, l'échantillon défilait à la vitesse de 7.5 m/mn,

L'observation du dépôt effectué dans ces conditions, à l'aide d'un microscope électronique à balayage a montré la formation d'un dépôt de particules submicroniques, le dépôt présentant un aspect parfaitement continu et dense. Il était notamment important de vérifier qu'un tel dépôt de bonne qualité pouvait intervenir dans des conditions de basse température, compatibles avec la nature du substrat traité.

Quoique la présente invention est été décrite en relation avec des modes de réalisations particuliers, elle ne s'en trouve pas limité pour autant mais est au contraire susceptible de modifications et de variantes qui apparaîtront à l'homme de l'art dans le cadre des revendications ci-après.

## Revendications

1. Procédé, pour former un dépôt d'un film contenant du silicium sur un substrat non métallique (1), selon lequel on dispose d'au moins un appareil aval (4) de formation d'espèces gazeuses excitées ou instables, dans lequel on transforme un mélange gazeux initial de traitement (7) en un mélange gazeux primaire de traitement (8), l'appareil étant le siège d'une décharge électrique créée entre une première électrode (14) et une seconde électrode (17), qui s'étendent selon une direction principale allongée, le mélange gazeux initial de traitement traversant la décharge transversalement aux électrodes et à cette direction principale, le mélange gazeux primaire de traitement (8) qui est obtenu à la sortie (6) de gaz dudit appareil, qui comprend des espèces gazeuses excitées ou instables et qui est substantiellement dépourvu d'espèces électriquement chargées, formant avec un mélange gazeux adjacent de traitement (9, 10) qui comprend au moins un précurseur gazeux du silicium et qui n'a pas transité par ledit appareil, l'atmosphère gazeuse de traitement (30) qui est mise en contact avec le substrat pour réaliser le dépôt.

2. Procédé selon la revendication 1, caractérisé en ce que la mise en contact de l'atmosphère gazeuse de traitement (30) avec le substrat est effectuée à une pression voisine de la pression atmosphérique.

3. Procédé selon l'une des revendications 1 ou 2, caractérisé en ce que une couche d'un matériau diélectrique, est disposée sur la surface d'au moins une des électrodes, en regard de l'autre électrode.

4. Procédé selon l'une des revendications 1 à 3, caractérisé en ce que, au préalable, ledit substrat a subit une préparation de surface par mise en contact avec une atmosphère gazeuse de préparation de surface, la dite atmosphère gazeuse de préparation de surface comprenant un mélange gazeux primaire de préparation, qui est obtenu à la sortie de gaz d'au moins un appareil amont (11) de formation d'espèces gazeuses excitées ou instables dans lequel a été transformé un mélange gazeux initial de préparation comprenant un gaz réducteur ou un gaz oxydant et le cas échéant au moins un gaz inerte, ledit mélange gazeux primaire de préparation étant substantiellement dépourvu d'espèces électriquement chargées.

5. Procédé selon la revendication 4, caractérisé en ce que la dite atmosphère gazeuse de préparation de surface comprend outre ledit mélange gazeux primaire de préparation, un mélange gazeux adjacent (29) de préparation, qui n'a pas transité par ledit appareil amont et qui ne comprend aucun précurseur gazeux du silicium.

6. Procédé selon la revendication 4 ou 5, caractérisé en ce que la mise en contact de l'atmosphère gazeuse de préparation avec le substrat est effectuée à une pression voisine de la pression atmosphérique.

7. Procédé selon l'une des revendications 4 à 6, caractérisé en ce que au moins un desdits appareils amont (11), dans lequel est transformé ledit mélange gazeux initial de préparation, est le siège d'une décharge électrique créée entre une première électrode (14) et une seconde électrode (17), qui s'étendent selon une direction principale allongée, le mélange gazeux initial de préparation traversant la décharge transversalement aux électrodes et à cette direction principale.

8. Procédé selon la revendication 7, caractérisé en ce que une couche (16) d'un matériau diélectrique est disposée sur la surface d'au moins une des électrodes (17), en regard de l'autre électrode.

9. Procédé selon l'une des revendications 1 à 8, caractérisé en ce que le dit mélange gazeux initial de traitement comprend un gaz inerte et/ou un gaz réducteur et/ou un gaz oxydant.

10. Procédé selon l'une des revendications 1 à 9, caractérisé en ce que le dit mélange gazeux adjacent de traitement comprend, en plus du ou des précurseurs gazeux du silicium, un gaz inerte et/ou un gaz réducteur, et le cas échéant un gaz oxydant.

11. Procédé selon l'une des revendications 1 à 10, caractérisé en ce que le précurseur gazeux du silicium est le monosilane SiH₄.

12. Procédé selon l'une des revendications 1 à 11, caractérisé en ce que le substrat à traiter est amené en regard de la sortie de gaz dudit appareil aval (4), le cas échéant en regard des sorties de gaz de plusieurs appareils aval placés en parallèle sur la largeur du substrat et/ou successivement en regard des sorties de gaz de plusieurs appareils aval (4, 12) placés en série, par un système de convoyage (2) traversant un espace intérieur (31) délimité par un ensemble (3) de capotage aval, isolé de l'atmosphère environnante, ledit ensemble aval, étant raccordé de façon étanche audit appareil aval ou incluant ledit appareil aval.

13. Procédé selon l'une des revendications 4 à 8, caractérisé en ce que le substrat (1) dont la surface est à préparer, est amené en regard de la sortie de gaz dudit appareil amont (11), le cas échéant en regard des sorties de gaz de plusieurs appareils amont placés en parallèle sur la largeur du substrat et/ou successivement en regard des sorties de gaz de plusieurs appareils amont placés en série, par un système de convoyage (2) traversant un espace intérieur (31) délimité par un ensemble (3) de capotage amont, isolé de l'atmosphère environnante, ledit ensemble amont, étant raccordé de façon étanche audit appareil amont ou incluant ledit appareil amont.

14. Procédé selon l'une des revendications 3 ou 8, caractérisé en ce que l'énergie mise en oeuvre dans le dit appareil, qu'il soit de type amont ou aval, ramenée à l'unité de surface de diélectrique est supérieure à 1 W/cm², préférentiellement supérieure à 10 W/cm².

15. Procédé selon la revendication 12, caractérisé en ce que l'on réalise un zonage de l'atmosphère de traitement rencontrée successivement par la pièce à traiter le long du convoyeur, de la façon suivante :
a) au moins un des appareils aval de formation d'espèces gazeuses excitées ou instables, transforme un mélange gazeux initial de traitement différent de celui transformé par l'appareil aval le précédant dans le dit ensemble aval, et/ou
b) le mélange gazeux adjacent de traitement mis en oeuvre au niveau d'au moins un des appareils aval de formation d'espèces gazeuses excitées ou instables est différent de celui mis en oeuvre au niveau de l'appareil aval le précédant dans le dit ensemble aval.

16. Procédé selon la revendication 15, caractérisé en ce que les étapes a) et b) ont lieu au niveau d'un même appareil aval.

17. Procédé selon la revendication 13, caractérisé en ce que l'on réalise un zonage de l'atmosphère de préparation rencontrée successivement par la pièce, dont la surface doit être préparée, le long du convoyeur, de la façon suivante : au moins un des appareils amont de formation d'espèces gazeuses excitées ou instables, transforme un mélange gazeux initial de préparation différent de celui transformé par l'appareil amont le précédant dans le dit ensemble amont.

18. Procédé selon la revendication 13, dans son rattachement à la revendication 5, caractérisé en ce que on réalise un zonage de l'atmosphère de préparation rencontrée successivement par la pièce, dont la surface doit être préparée, le long du convoyeur, de la façon suivante :
a) au moins un des appareils amont de formation d'espèces gazeuses excitées ou instables, transforme un mélange gazeux initial de préparation différent de celui transformé par l'appareil amont le précédant dans le dit ensemble amont, et/ou
b) le mélange gazeux adjacent de préparation mis en oeuvre au niveau d'au moins un des appareils amont de formation d'espèces gazeuses excitées ou instables est différent de celui mis en oeuvre au niveau de l'appareil amont le précédant dans le dit ensemble amont.

19. Procédé selon la revendication 18, caractérisé en ce que les étapes a) et b) ont lieu au niveau d'un même appareil amont.

20. Dispositif convenant notamment pour la mise en oeuvre de l'une des revendications 1 à 19, comprenant un ensemble (3) de capotage définissant un espace intérieur (31) traversé par des moyens de convoyage (2) des substrats à traiter, isolé de l'atmosphère environnante, se raccordant de façon étanche à ou incluant un ou plusieurs appareils (11, 4, 12) de formation d'espèces gazeuses excitées ou instables montés en série et/ou parallèle, comprenant au moins un passage (18) de gaz tubulaire ayant un axe, formé entre une électrode extérieure (14) et une électrode intérieure (17), l'une au moins des électrodes comportant, en regard de l'autre, un revêtement diélectrique (16), les électrodes étant reliées à une source haute tension et haute fréquence, l'électrode extérieure (14) entourant le diélectrique (16) et comportant une entrée (20) de gaz initial et une sortie (21) de gaz primaire allongées, parallèles à l'axe et sensiblement diamétralement opposées, ladite sortie de gaz débouchant à l'intérieur dudit ensemble, qui est muni d'au moins un moyen d'injection (9, 10, 13) d'un gaz adjacent n'ayant pas transité par le ou les dits appareils.

## Patentansprüche

1. Verfahren zur Erzeugung einer Abscheidung eines Silicium enthaltenden Films auf einem nichtmetallischen Substrat (1), gemäß welchem über wenigstens ein stromabwärtiges Gerät (4) zur Herstellung von angeregten oder instabilen Gasarten verfügt wird, in dem ein Behandlungs-Ausgangsgasgemisch (7) in ein Behandlungs-Primärgasgemisch (8) umgewandelt wird, wobei das Gerät der Ort einer elektrischen Entladung ist, die zwischen einer ersten Elektrode (14) und einer zweiten Elektrode (17), die sich gemäß einer länglichen Hauptrichtung erstrecken, erzeugt wird, wobei das Behandlungs-Ausgangsgasgemisch die Entladung quer zu den Elektroden und zu dieser Hauptrichtung durchströmt und das Behandlungs-Primärgasgemisch (8), das am Gasauslaß (6) des Geräts erhalten wird, das angeregte oder instabile Gasarten enthält und das im wesentlichen frei von elektrisch geladenen Arten ist, mit einem angrenzenden Behandlungs-Gasgemisch (9,10), das wenigstens eine gasförmige Silicium-Vorstufe enthält und das nicht durch das Gerät geleitet wurde, die Behandlungs-Gasatmosphäre (30) bildet, die mit dem Substrat in Kontakt gebracht wird, um die Abscheidung auszuführen.

2. Verfahren nach Anspruch 1, dadurch gekennzeichnet, daß der Kontakt der Behandlungs-Gasatmosphäre (30) mit dem Substrat bei einem Druck um den Atmosphärendruck erfolgt.

3. Verfahren nach einem der Ansprüche 1 oder 2, dadurch gekennzeichnet, daß eine Schicht aus einem dielektrischen Material auf der Oberfläche wenigstens einer der Elektroden gegenüber der anderen Elektrode angeordnet ist.

4. Verfahren nach einem der Ansprüche 1 bis 3, dadurch gekennzeichnet, daß das Substrat zuvor einer Oberflächenvorbehandlung durch Kontakt mit einer Gasatmosphäre zur Oberflächenvorbehandlung unterzogen wurde, wobei die Gasatmosphäre zur Oberflächenvorbehandlung ein VorbehandlungsPrimärgasgemisch enthält, das erhalten wird am Gasauslaß von wenigstens einem stromaufwärtigen Gerät (11) zur Herstellung von angeregten oder instabilen Gasarten, in welchem ein Vorbehandlungs-Ausgangsgasgemisch, das ein Reduktionsgas oder ein oxidierendes Gas und gegebenenfalls wenigstens ein inertes Gas aufweist, umgewandelt wurde, wobei das Vorbehandlungs-Primärgasgemisch im wesentlichen frei von elektrisch geladenen Arten ist.

5. Verfahren nach Anspruch 4, dadurch gekennzeichnet, daß die Gasatmosphäre zur Oberflächenvorbehandlung außer dem Vorbehandlungs-Primärgasgemisch ein angrenzendes Vorbehandlungs-Gasgemisch (29) aufweist, das nicht durch das stromaufwärtige Gerät geleitet wurde und das keine gasförmige Silicium-Vorstufe aufweist.

6. Verfahren nach Anspruch 4 oder 5, dadurch gekennzeichnet, daß der Kontakt der Vorbehandlungs-Gasatmosphäre mit dem Substrat bei einem Druck um den Atmosphärendruck erfolgt.

7. Verfahren nach einem der Ansprüche 4 bis 6, dadurch gekennzeichnet, daß wenigstens eines der stromaufwärtigen Geräte (11), in denen das Vorbehandlungs-Ausgangsgasgemisch umgewandelt wird, der Ort einer elektrischen Entladung ist, die zwischen einer ersten Elektrode (14) und einer zweiten Elektrode (17), die sich gemäß einer länglichen Hauptrichtung erstrecken, erzeugt wird, wobei das Vorbehandlungs-Ausgangsgasgemisch die Entladung quer zu den Elektroden und zu dieser Hauptrichtung durchquert.

8. Verfahren nach Anspruch 7, dadurch gekennzeichnet, daß eine Schicht (16) aus einem dielektrischen Material auf der Oberfläche wenigstens einer der Elektroden (17) gegenüber der anderen Elektrode angeordnet ist.

9. Verfahren nach einem der Ansprüche 1 bis 8, dadurch gekennzeichnet, daß das Behandlungs-Ausgangsgasgemisch ein inertes Gas und/oder ein Reduktionsgas und/oder ein oxidierendes Gas enthält.

10. Verfahren nach einem der Ansprüche 1 bis 9, dadurch gekennzeichnet, daß das angrenzende Behandlungs-Gasgemisch zusätzlich zu der oder den gasförmigen Vorstufe(n) des Siliciums ein inertes Gas und/oder ein Reduktionsgas und gegebenenfalls ein oxidierendes Gas enthält.

11. Verfahren nach einem der Ansprüche 1 bis 10, dadurch gekennzeichnet, daß die gasförmige Silicium-Vorstufe das Monosilan SiH₄ ist.

12. Verfahren nach einem der Ansprüche 1 bis 11, dadurch gekennzeichnet, daß das zu behandelnde Substrat in Position gegenüber dem Gasauslaß des stromabwärtigen Geräts (4), gegebenenfalls gegenüber den Gasauslässen mehrerer parallel über die Breite des Substrats angeordneter stromabwärtiger Geräte und/oder aufeinanderfolgend in Position gegenüber den Gasauslässen mehrerer in Reihe angeordneter stromabwärtiger Geräte (4,12), mittels eines Fördersystems (2) geführt wird, das einen inneren, von einer stromabwärtigen Verkleidungs-Einheit (3) begrenztem Raum (31) durchquert, der von der umgebenden Atmosphäre isoliert ist, wobei die stromabwärtige Einheit hermetisch mit dem stromabwärtigen Gerät zusammengeschlossen ist oder das stromabwärtige Gerät umschließt.

13. Verfahren nach einem der Ansprüche 4 bis 8, dadurch gekennzeichnet, daß das Substrat (1), dessen Oberfläche vorzubehandeln ist, in Position gegenüber dem Gasauslaß des stromaufwärtigen Geräts (11), gegebenenfalls gegenüber den Gasauslässen mehrerer parallel über die Breite des Substrats angeordneter stromaufwärtiger Geräte und/oder aufeinanderfolgend in Position gegenüber den Gasauslässen mehrerer in Reihe angeordneter stromaufwärtiger Geräte, mittels eines Fördersystems (2) geführt wird, das einen inneren, von einer stromaufwärtigen Verkleidungs-Einheit (3) begrenztem Raum (31) durchquert, der von der umgebenden Atmosphäre isoliert ist, wobei die stromaufwärtige Einheit hermetisch mit dem stromaufwärtigen Gerät zusammengeschlossen ist oder das stromaufwärtige Gerät umschließt.

14. Verfahren nach einem der Ansprüche 3 oder 8, dadurch gekennzeichnet, daß die Energie, die in dem Gerät des stromaufwärtigen oder stromabwärtigen Typs aufgewendet wird, bezogen auf die Flächeneinheit des Dielektrikums, oberhalb 1 W/cm² und bevorzugt oberhalb 10 W/cm² liegt.

15. Verfahren nach Anspruch 12, dadurch gekennzeichnet, daß eine Zoneneinteilung der Behandlungsatmosphäre, die aufeinanderfolgend auf das zu behandelnde Werkstück längs des Förderbands auftrifft, auf folgende Weise durchgeführt wird;
a) wenigstens eines der stromabwärtigen Geräte zur Herstellung von angeregten oder instabilen Gasarten wandelt ein Behandlungs-Ausgangsgasgemisch um, das sich von demjenigen unterscheidet, das mittels des vorangehenden stromabwärtigen Geräts in der stromabwärtigen Einheit umgewandelt wird, und/oder
b) das angrenzende Behandlungs-Gasgemisch, das im Bereich wenigstens eines der stromabwärtigen Geräte zur Herstellung angeregter oder instabiler Gasarten eingesetzt wird, unterscheidet sich von demjenigen, das im Bereich des vorangehenden stromabwärtigen Geräts in der stromabwärtigen Einheit eingesetzt wird.

16. Verfahren nach Anspruch 15, dadurch gekennzeichnet, daß die Schritte a) und b) im Bereich des gleichen stromabwärtigen Geräts stattfinden.

17. Verfahren nach Anspruch 13, dadurch gekennzeichnet, daß eine Zoneneinteilung der Vorbehandlungs-Atmosphäre, die aufeinanderfolgend auf das Werkstück, dessen Oberfläche vorzubehandeln ist, längs des Förderbands auftrifft, auf folgende Weise durchgeführt wird: wenigstens eines der stromaufwärtigen Geräte zur Herstellung von angeregten oder instabilen Gasarten wandelt ein Vorbehandlungs-Ausgangsgasgemisch um, das sich von demjenigen unterscheidet, das mittels des vorangehenden stromaufwärtigen Geräts in der stromaufwärtigen Einheit umgewandelt wurde.

18. Verfahren nach Anspruch 13 in dessen Verbindung mit Anspruch 5, dadurch gekennzeichnet, daß eine Zoneneinteilung der Vorbehandlungs-Atmosphäre, die aufeinanderfolgend auf das Werkstück, dessen Oberfläche vorzubehandeln ist, längs des Förderbands auftrifft, auf folgende Weise durchgeführt wird:
a) wenigstens eines der stromaufwärtigen Geräte zur Herstellung von angeregten oder instabilen Gasarten wandelt ein Vorbehandlungs-Ausgangsgasgemisch um, das sich von demjenigen unterscheidet, das mittels des vorangehenden stromaufwärtigen Geräts in der stromaufwärtigen Einheit umgewandelt wird, und/oder
b) das angrenzende Vorbehandlungs-Gasgemisch, das im Bereich wenigstens eines der stromaufwärtigen Geräte zur Herstellung angeregter oder instabiler Gasarten eingesetzt wird, unterscheidet sich von demjenigen, das im Bereich des vorangehenden stromaufwärtigen Geräts in der stromaufwärtigen Einheit eingesetzt wird.

19. Verfahren nach Anspruch 18, dadurch gekennzeichnet, daß die Schritte a) und b) im Bereich des gleichen stromaufwärtigen Geräts stattfinden.

20. Vorrichtung, die insbesondere zur Ausführung eines der Ansprüche 1 bis 19 geeignet ist und die eine Verkleidungs-Einheit (3) aufweist, die einen inneren Raum (31) definiert, der von Mitteln zur Förderung (2) der zu behandelnden Substrate durchquert wird, von der umgebenden Atmosphäre isoliert ist und hermetisch mit einem oder mehreren Geräten (11,4,12) zur Herstellung von angeregten oder instabilen Gasarten verbunden ist oder diese umschließt, die in Reihe und/oder parallel angeordnet sind und wenigstens einen röhrenförmigen, eine Achse aufweisenden Gasdurchgang (18) enthalten, der zwischen einer äußeren Elektrode (14) und einer inneren Elektrode (17) gebildet wird, wobei wenigstens eine der Elektroden eine der anderen gegenüberliegende dielektrische Umhüllung (16) aufweist, die Elektroden an eine Hochspannungs- und Hochfrequenz-Quelle angeschlossen sind und die äußere Elektrode (14) das Dielektrikum (16) umgibt und einen Einlaß (20) für das Ausgangsgas und einen Gasaustritt (21) für das Primärgas aufweist, die parallel zur Achse verlängert sind und sich in etwa diametral gegenüberliegen, wobei der Gasaustritt in das Innere dieser Einheit einmündet, die mit wenigstens einem Einspeisungsmittel (9,10,13) für ein angrenzendes Gas, das nicht durch das Gerät oder die Geräte geleitet wurde, ausgestattet ist.

## Claims

1. Process for forming a deposit of a film containing silicon on a non-metallic substrate (1), according to which use is made of at least one downstream apparatus (4) for forming excited or unstable gaseous species, in which an initial gaseous treatment mixture (7) is converted into a primary gaseous treatment mixture (8), the apparatus being the seat of an electric discharge created between a first electrode (14) and a second electrode (17), which extend in a principal elongated direction, the initial gaseous treatment mixture passing through the discharge transversely to the electrodes and to this principal direction, the primary gaseous treatment mixture (8) which is obtained at the gas outlet (6) of the said apparatus, which includes excited or unstable gaseous species and which is substantially free from electrically charged species, forming with an adjacent gaseous treatment mixture (9, 10) which includes at least one gaseous precursor of silicon and which has not passed through the said apparatus, the gaseous treatment atmosphere (30) which is put into contact with the substrate to produce the deposit.

2. Process according to claim 1, characterized in that the gaseous treatment atmosphere (30) is put into contact with the substrate at a pressure close to atmospheric pressure.

3. Process according to either of claims 1 or 2,
characterized in that a layer of a dielectric material is deposited on the surface of at least one of the electrodes, facing the other electrode.

4. Process according to one of claims 1 to 3,
characterized in that the said substrate has first of all been subjected to a surface preparation by being put into contact with a gaseous atmosphere for preparing a surface, the said gaseous atmosphere for preparing a surface comprising a primary gaseous preparation mixture, which is obtained at the gas outlet from at least one upstream apparatus (11) for forming excited or unstable gaseous species in which there has been converted an initial gaseous preparation mixture including a reducing gas or an oxidizing gas and where appropriate at least one inert gas, the said primary gaseous preparation mixture being substantially free from electrically charged species.

5. Process according to claim 4, characterized in that the said gaseous atmosphere for preparing a surface includes, apart from the said primary gaseous preparation mixture, an adjacent gaseous preparation mixture (29) which has not passed through the said upstream apparatus and which does not include any gaseous precursor of silicon.

6. Process according to claim 4 or 5, characterized in that the gaseous preparation atmosphere is put into contact with the substrate at a pressure close to atmospheric pressure.

7. Process according to one of claims 4 to 6,
characterized in that at least one of the said upstream apparatuses (11), in which the initial gaseous preparation mixture is converted, is the seat of an electric discharge created between a first electrode (14) and a second electrode (17), which extend in a principal elongated direction, the initial gaseous treatment mixture passing through the discharge transversely to the electrodes and to this principal direction.

8. Process according to claim 7, characterized in that a layer (16) of a dielectric material is deposited on the surface of at least one of the electrodes (17), facing the other electrode.

9. Process according to one of claims 1 to 8,
characterized in that the said initial gaseous treatment mixture includes an inert gas and/or a reducing gas and/or an oxidizing gas.

10. Process according to one of claims 1 to 9,
characterized in that the said adjacent gaseous treatment mixture includes, in addition to the gaseous precursor or precursors of silicon, an inert gas and/or a reducing gas and where appropriate an oxidizing gas.

11. Process according to one of claims 1 to 10,
characterized in that the gaseous precursor of silicon is monosilane, SiH₄.

12. Process according to one of claims 1 to 11,
characterized in that the substrate to be treated is brought facing the gas outlet of the said downstream apparatus (4), and where appropriate facing the gas outlets of several downstream apparatuses placed in parallel over the width of the substrate and/or successively facing the gas outlets of several downstream apparatuses (4, 12) placed in series, by a conveyer system (2) passing through an inner space (31) delimited by a downstream cowling assembly (3), isolated from the surrounding atmosphere, the said downstream assembly being connected in a leakproof manner to the said downstream apparatus or including the said downstream apparatus.

13. Process according to one of claims 4 to 8,
characterized in that the substrate (1) of which the surface is to be prepared, is brought facing the gas outlet of the said upstream apparatus (11), and where appropriate facing the gas outlets of several upstream apparatuses placed in parallel over the width of the substrate and/or successively facing the gas outlets of several upstream apparatuses placed in series, by a conveyer system (2) passing through an inner space (31) delimited by an upstream cowling assembly (3), isolated from the surrounding atmosphere, the said upstream assembly being connected in a leakproof manner to the said upstream apparatus or including the said upstream apparatus.

14. Process according to either of claims 3 or 8,
characterized in that the energy used in the said apparatus, whether it be of the upstream or downstream type, reduced to unit surface area of the dielectric, is greater than 1 W/cm², preferably greater than 10 W/cm².

15. Process according to claim 12, characterized in that the treatment atmosphere encountered successively by the part to be treated, is split into zones along the conveyer in the following manner :
a) at least one of the downstream apparatuses for forming excited or unstable gaseous species converts an initial gaseous treatment mixture different from that converted by the downstream apparatus preceding it in the said downstream assembly, and/or
b) the adjacent gaseous treatment mixture used in at least one of the downstream apparatuses for forming excited or unstable species is different from that used in the downstream apparatus preceding it in the said downstream assembly.

16. Process according to claim 15, characterized in that the steps a) and b) take place in the same downstream apparatus.

17. Process according to claim 13, characterized in that the preparation atmosphere encountered successively by the part of which the surface must be prepared, is split up into zones along the conveyer in the following manner : at least one of the upstream apparatuses for forming excited or unstable gaseous species converts an initial gaseous preparation mixture different from that converted by the upstream apparatus preceding it in the said upstream assembly.

18. Process according to claim 13, in its association with claim 5, characterized in that the preparation atmosphere encountered successively by the part, of which the surface must be prepared, is split into zones along the conveyer in the following manner :
a) at least one of the upstream apparatuses for forming excited or unstable gaseous species converts an initial gaseous preparation mixture different from that converted by the upstream apparatus preceding it in the said upstream assembly, and/or
b) the adjacent gaseous preparation mixture used in at least one of the upstream apparatuses for forming excited or unstable species is different from that used in the upstream apparatus preceding it in the said upstream assembly.

19. Process according to claim 18, characterized in that the steps a) and b) take place in the same upstream apparatus.

20. Device suitable in particular for implementing one of claims 1 to 19, including a cowling assembly (3) defining an inner space (31) traversed by means (2) for conveying the substrates to be treated, isolated from the surrounding atmosphere, connected in a leakproof manner to or including one or more apparatuses (11, 4, 12) for forming excited or unstable gaseous species, mounted in series and/or in parallel, including at least one tubular gas passage (18) having an axis, formed between an outer electrode (14) and inner electrode (17), at least one of the electrodes having, facing the other, a dielectric coating (16), the electrodes being connected to a high voltage, high frequency source, the outer electrode (14) surrounding the dielectric (16) and including an elongated initial gas inlet (20) and an elongated primary gas outlet (21), parallel to the axis and substantially diametrically opposite it, the said gas outlet emerging inside the said assembly, which is provided with at least one means (9, 10, 13) for injecting an adjacent gas which has not passed through the said apparatus or apparatuses.
